# EUROPÄISCHE PATENTANMELDUNG

(11) **EP 4 801 218 A1**
(43) Veröffentlichungstag der Anmeldung: **02.09.2026**
(21) Anmeldenummer: 25160593.7
(22) Anmeldetag: 27.02.2025
(51) Int. Cl.: H05K 13/04, H05K 13/08

(54) **VERFAHREN UND SYSTEM ZUM BESTÜCKEN VON LEITERPLATTEN EINES ODER MEHRERER LEITERPLATTENTYPEN AUF EINER BESTÜCKUNGSLINIE MITTELS EINER PIPETTENWECHSLERRÜSTUNG**

(71) Anmelder: Siemens Aktiengesellschaft, 80333 München (DE)
(72) Erfinder: Fige, Peter, 80687 München (DE); Hupp, Lena, 81476 München (DE); Pfaffinger, Alexander, 81739 München (DE); Royer, Christian, 85521 Ottobrunn (DE); Seipp, Florian, 81375 München (DE); Wirth, Andreas, 92263 Pittersberg (DE); Zenger, Stefan, 92533 Wernberg-Köblitz (DE)
(74) Vertreter: Siemens Patent Attorneys

(57) **Zusammenfassung**

Die Erfindung betrifft ein Verfahren zum Bestücken von Leiterplatten (LP1, LP2) eines oder mehrerer zu fertigenden Leiterplattentypen auf einer Bestückungslinie (BL1, BL2, BL3) mittels einer Pipettenwechslerrüstung von Pipetten eines oder mehrerer verschiedener Pipettentypen in einem oder mehreren Pipettenwechslern (PW), wobei eine oder mehrere gerüstete Pipetten jeweils von einem Segment eines Bestückungskopf (KT1, KT2, KT3; KR) aufgenommen werden können, dadurch gekennzeichnet, dass computergestützt für eine Menge an zu bestückenden Leiterplatten eine oder mehrere mit Pipetten fest gerüstete Pipettenwechslerfestrüstungen mit einem Optimierungskriterium über einen vorgebbaren Planungszeitraum bestimmt werden, wobei mit Hilfe der einen oder mehreren bestimmten Pipettenwechslerfestrüstungen alle Leiterplatten der Bestückungslinie bestückt werden können und wobei das Optimierungskriterium ein Maximum der Summe der Anzahlen der auf die Leiterplatten setzbaren Bauelemente über alle Pipettenwechsler zum Ziel hat.

## Beschreibung

Die Erfindung betrifft ein Verfahren zum Bestücken von Leiterplatten eines oder mehrerer Leiterplattentypen auf einer Bestückungslinie mittels einer Pipettenwechslerrüstung von einem oder mehreren Pipettentypen in einem oder mehreren Pipettenwechsler und zugehöriges System sowie ein zugehöriges Computerprogrammprodukt.

Insbesondere im Bereich der Elektronikproduktion werden zu fertigende Leiterplatten bzw. Baugruppen auf SMT-Bestückungslinien durch Oberflächenmontage (SMT = surface mounted technology) hergestellt. Die Elektronikproduktion bzw. -fertigung ist geprägt durch hohe Anforderungen an kurze Durchlaufzeiten, hohe Produktivität (u.a. kurze Umrüstzeiten, kurze Produktionszeiten, usw.) und hohe Flexibilität.

Mehrere Bestückungsautomaten, die üblicherweise durch ein Transportsystem verbunden sind, und die z.B. zum Fertigen bzw. Bestücken von (Elektronik-)baugruppen zusammenwirken, stellen eine Bestückungslinie dar. Ein Bestückungssystem, das ein oder mehrere (Bestückungs)linien umfasst, bildet damit eine Gruppe, auch in diesem Kontext Cluster genannt, von einer oder mehreren Bestückungslinien. Jede Gruppe kann hierbei in einer Produktionsstätte angeordnet sein.

In den industriellen Fertigungswerken im Bereich der Elektronikproduktion werden zu fertigende Baugruppen (bzw. Leiterplatten) in Aufträgen mit fest vorgegebenen Losgrößen produziert.

Durch die Losgrößen wird implizit festgelegt, wie häufig eine Baugruppe zu produzieren ist. Je kleiner die Losgröße einer Baugruppe ist, umso häufiger muss diese Baugruppe produziert werden und umso größer sind die Rüstaufwände.

Die Erstellung einer (Bauelement-)Rüstung, auch Setup genannt, für eine Bestückungslinie benötigt ca. 6-8 Stunden und verursacht somit einen enormen Aufwand. Die Produktion der Baugruppen erfolgt häufig in sogenannten Rüstfamilien. Eine Rüstfamilie ist dabei eine Menge von Baugruppentypen, die mit einer Rüstung auf der Bestückungslinie produzierbar sind.

Mit anderen Worten ausgedrückt umfasst eine Rüstfamilie eine Menge von Losen, die innerhalb einer Rüstung gefertigt werden kann. Alle Baugruppen der Baugruppentypen einer Rüstfamilie können also nacheinander ohne Umrüsten auf der Bestückungslinie gefertigt werden.

Eine Rüstung kann auf einem oder mehreren (Rüst-)tischen gehalten werden, die leicht am Bestückungsautomaten ausgewechselt werden können. Ein Aufrüsten eines Rüsttischs mit Bauelementen von vorbestimmten Bauelementtypen ist jedoch aufwändig.

Auf den SMT-Linien in den Elektronikwerken werden die Baugruppen mit unzähligen unterschiedlichen elektronischen Bauelementen bestückt. Einer SMT-Linie ist mittel- bis langfristig meist eine gewisse Menge von Baugruppen zur Bestückung zugeordnet. Die Produktion ist geprägt durch wettbewerbsbedingte Anforderungen an kurze Durchlaufzeiten, hohe Produktivität (u.a. kurze Umrüstzeiten, kurze Produktionszeiten, usw.) und hohe Flexibilität.

Die zugewiesenen Baugruppen werden an den Maschinen einer (Bestückungs-)Linie mit Hilfe derer Bestückköpfe mit den benötigten Bauteilen bestückt. Ein Bestückkopf besitzt ein oder mehrere Segmente, an denen Pipetten gerüstet werden können. Mit einer am Kopf gerüsteten Pipette können wiederum Bauelemente bzw. Bauteile, die gewisse Bauteiltypen aufweisen, aufgenommen und platziert werden.

Die Pipetten werden in Pipettenwechslern der Bestückungslinie gerüstet und bereitgestellt. Eine Pipette, die von einem Bestückkopf zur Bestückung benötigt wird, muss in einem Pipettenwechsler gerüstet werden, auf den der Bestückkopf Zugriff hat.

Es gibt einen oder mehrere Bestückköpfe, die aus einem Pipettenwechsler Pipetten aufnehmen und zur Bestückung verwenden können. Mit den aufgenommenen Pipetten können die Bestückköpfe dann von einem oder mehreren Tischen der Bestückungslinie Bauelemente abholen und damit eine Leiterplatte bestücken.

Pipettenwechsler
- Pipettenwechsler besitzen Magazine mit Fächern bzw. Aufbewahrungsbehältern, in denen die Pipetten aufbewahrt werden.
- Ein Magazin darf je nach Einstellung unterschiedliche oder nur gleiche Pipetten eines (Pipetten-)Typs enthalten.

Sind in den Pipettenwechslern einer Bestückungslinie Pipetten gerüstet, so wird dies als Pipettenwechslerrüstung der Bestückungslinie bezeichnet.

Da es äußerst zeitaufwändig ist, Pipetten in die Pipettenwechsler zu rüsten bzw. zu wechseln, ist es das Ziel, die Pipettenwechsler einer Bestückungslinie mit Pipetten möglichst langfristig "ohne Veränderung" zu rüsten, bis sich das zu bestückende Leiterplattenspektrum der Bestückungslinie wieder ändert.

Es gibt beispielsweise von der Firma ASMPT SMT Solutions eine Planungssoftware, die Aufträge optimal auf die einzelnen Produktionslinien verteilt und sie in Familienrüstungen zusammenfasst (https://smt.asmpt.com/de/produkte/software-solutions/works/works-planning/).

Bisher wird oft manuell versucht, eine Pipettenwechslerrüstung zu finden, die für alle der Linie zugewiesenen Leiterplatten verwendet werden können. Dies ist allerdings sehr komplex. Ist eine Pipettenwechslerrüstung gefunden worden, dann zieht dies oft eine Änderung in der die Baugruppentyp-Linien Verteilung nach sich. Dies ist allerdings sehr zeitaufwändig und die resultierende Lösung führt gewöhnlich auch zu deutlich schlechteren Produktionszeiten.

Es ist Aufgabe der Erfindung, über einen Planungszeit zumindest eine Pipettenwechslerrüstung für die Bestückköpfe einer Bestückungslinie für eine Menge von Baugruppen- bzw. Leitplattentypen so zu bestimmen, dass Umrüstzeiten vermieden werden können.

Diese Aufgabe wird durch die unabhängigen Ansprüche gelöst. Vorteilhafte Weiterbildungen sind Gegenstand der abhängigen Ansprüche.

Die Erfindung bezieht sich auf ein Verfahren zum Bestücken von Leiterplatten eines oder mehrerer zu fertigenden Leiterplattentypen auf einer Bestückungslinie mittels einer Pipettenwechslerrüstung von Pipetten eines oder mehrerer verschiedener Pipettentypen in einem oder mehreren Pipettenwechslern, wobei eine oder mehrere gerüstete Pipetten jeweils von einem Segment eines Bestückungskopf aufgenommen werden können, dadurch gekennzeichnet, dass computergestützt für eine Menge an zu bestückenden Leiterplatten eine oder mehrere mit Pipetten fest gerüstete Pipettenwechslerfestrüstungen mit einem Optimierungskriterium über einen vorgebbaren Planungszeitraum bestimmt werden, wobei mit Hilfe der einen oder mehreren bestimmten Pipettenwechslerfestrüstungen alle Leiterplatten der Bestückungslinie bestückt werden können und wobei das Optimierungskriterium ein Maximum der Summe der Anzahlen der auf die Leiterplatten setzbaren Bauelemente über alle Pipettenwechsler zum Ziel hat.

Das obige Verfahren kann beliebig oft iteriert werden.

Erfindungsgemäß werden die Pipettenwechsler einer Bestückungslinie mit Pipetten möglichst langfristig fest gerüstet, bis sich das zu bestückende Leiterplattenspektrum der Bestückungslinie wieder ändert. Dann spricht man von einer Pipettenwechslerfestrüstung. Zur Bestückung werden dann nur die "fixen" Pipetten in den Pipettenwechslern verwendet. Damit wird der Zeitaufwand reduziert, Pipetten in die Pipettenwechsler zu rüsten bzw. zu wechseln.

Die Bestückung der Leiterplatten mittels der einen oder mehreren bestimmten Pipettenwechslerfestrüstungen durchgeführt wird.

Vorzugsweise wird das Ergebnisses der bestimmten Pipettenwechslerrüstung(en) an eine zur Steuerung und/oder Regelung ausgegeben bzw. die bestimmten Pipettenwechslerrüstung (en) können in computerlesbarer Form ausgegeben werden. Mit der Steuerung bzw. Regelung, wird die Bestückung der Leiterplatten letztendlich ausgeführt.

Im Vorfeld kann der Bestückungslinie Leiterplatten zugeordnet werden. Abhängig von der der einen oder mehreren Pipettenwechslerfestrüstungen kann die Leiterplattenzuordnung geändert werden, damit die Typen der Pipetten in den Pipettenwechslerfestrüstung(en) zu den benötigten Bauelementtypen passen, deren Bauelemente zur Bestückung der zugeordneten Leiterplatten verwendet werdet werden.

Die Pipettenwechslerfestrüstung soll vorzugsweise so bestimmt werden, dass es für jeden Bauelementtyp einer ersten Menge von Bauelementtypen, dessen Bauelemente, mit denen die zu fertigenden Leiterplatten zu bestücken sind, mit Bestückköpfen gesetzt werden müssen, die aus den Pipettenwechslerfestrüstungen Pipetten aufnehmen, einen Pipettenwechsler gibt, in dem zumindest eine Pipette passend zum jeweiligen oben genannten Bauelementtyp gerüstet wird. Mit anderen Worten ausgedrückt, gibt es zum einen Bauelemente aus der ersten Menge von Bauelementtypen, die unbedingt mit einer ersten Art von Bestückköpfen z.B. Twinhead gesetzt werden müssen.

Für jeden Bauelementtyp einer zweiten Menge von Bauelementtypen ohne der ersten Menge von Bauelementtypen, dessen Bauelemente, mit denen die zu fertigenden Leiterplatten zu bestücken sind, mit Bestückköpfen gesetzt werden können, die aus den Pipettenwechslerfestrüstungen Pipetten aufnehmen, einen Pipettenwechsler gibt, in dem zumindest eine Pipette passend zum jeweiligen oben genannten Bauelementtyp gerüstet wird.

Mit anderen Worten ausgedrückt, gibt es zum anderen Bauelemente aus der zweiten Menge von Bauelementtypen, die zwar auch mit anderen Arten von Bestückköpfen z.B. Revolverkopf gesetzt werden könnten, aber für die es vorteilhaft sein kann, wenn sie mit einem Bestückkopf der ersten Art z.B. Twinhead bestückt werden, da mit diesem Bestückungskopf der ersten Art die Gesamtbestückzeit vermindert werden kann.

Jeder Bestückkopf soll von einem oder mehreren Tischen (T) der Bestückungslinien Bauelemente eines Bauelementtyps, der zum Pipettentyp einer der aufgenommenen Pipetten passt, abholen können und damit die Bestückungspositionen einer Leiterplatte setzen können.

Wenn ein Bestückungskopf n Segmente zur Aufnahme der n Pipetten aufweist, dann sollten auch n Pipetten eines Pipettentyps im Pipettenwechsler, aus dem der Bestückkopf die Pipetten aufnimmt, gerüstet werden.

Insbesondere bei Twinhead-Köpfen, also Bestückköpfe mit zwei Segmenten, ist es schwierig, für alle der Linie zugewiesenen Leiterplatten fixe Pipettenwechslerrüstungen zu finden, da diese Bestückungsköpfe eine sehr große Vielzahl an unterschiedlichen Pipettentypen zur Bestückung benötigen und die Kapazitäten der Pipettenwechsler verhältnismäßig gering sind.

Die jeweiligen Kapazitäten des einen oder mehreren Pipettenwechslers werden vorzugsweise berücksichtigt. Zudem wird insbesondere auch die Beschaffenheit von Pipettenmagazinen innerhalb der Pipettenwechsler berücksichtigt. Beispielweise gibt es Einzelgaragen, d.h. Magazine mit nur jeweils einem Fach, in denen nur Pipetten eines bestimmten Typs gerüstet werden dürfen. Es sind auch Doppelgaragen mit zwei Fächern oder Garagen mit mehr als zwei Fächern möglich, in die auch nur Pipetten eines anderen bestimmten Typs passen.

Auch bei Linien-Cluster mit mehreren gleichen Linien eines Typs lassen sich damit die zugewiesenen Leiterplatten flexibel auf allen Linien des Clusters fertigen und es kann mit den bestimmten fixe und gleiche Pipettenwechslerrüstungen eine kontinuierlich gleichmäßigere Auslastung der Linien erreicht werden. Bei Linien-Cluster ist das Auffinden einer für alle Linien gleichen fixen Pipettenwechslerrüstung besonders schwierig, da dort eine sehr große Vielfalt an Leiterplattentypen gefertigt wird und damit eine entsprechend hohe Anzahl an unterschiedlicher Bauelementtypen zu setzen ist.

Zusätzlich kann eine Gewichtung zwischen dem Ziel, die Summe der Anzahlen der setzbaren Bauelementtypen über alle Pipettenwechsler zu maximieren, und dem Ziel, die Summe der Anzahlen an Bestückpositionen über alle Pipettenwechsler zu maximieren, die mit mindestens zwei Pipetten eines Pipettentyps aus dem jeweiligen Pipettenwechsler gesetzt werden können, gewählt werden.

Zur Bestimmung der einen oder mehreren bestimmten Pipettenwechslerfestrüstungen werden insbesondere folgende Daten als Eingabedaten folgende Daten verwendet:
- Menge der Leiterplattentypen;
- Menge der Pipettentypen;
- Menge der Pipettenwechsler;
- Menge der Bauelementtypen eines Leiterplattentyps, die mit Pipetten aus der Pipettentypmenge gesetzt werden können;
- Menge der Pipettenwechsler, auf die Bestückköpfe Zugriff haben, die Bauelemente eines bestimmten Bauelementtyps setzen können und diese von Tischen abholen dürfen, auf denen Bauelemente dieses Bauelementtyps gerüstet werden;
- Menge der Pipettentypen, mit denen Bauelemente eines bestimmten Bauelementtyps gesetzt werden können;
- Menge der Pipettentypen, die in einem bestimmten Pipettenwechsler gerüstet werden dürfen;
- Menge der Bauelementtypen, die mit einem bestimmten Pipettentyp von auf den entsprechenden Pipettenwechsler zugreifbaren Bestückköpfen gesetzt werden können,
- Anzahl der zur Bestückung zu verwendenden Bauelemente pro Bauelementtyp für alle zu bestückenden Leiterplatten.

Das erfindungsgemäße Verfahren ist vorzugsweise computerimplementiert ausgestaltet.

In einer besonders bevorzugten Ausführungsform erfolgt das Bestimmen der Pipettenwechslerfestrüstung mittels Gemischt Ganzzahliger Programmierung. Die Gemischt Ganzzahlige Programmierung stellt einen globalen Optimierungsansatz dar, der leicht erweiterbar ist und für die kommerzielle Lösungsverfahren bzw. Lösungsvorrichtungen, auch Solver genannt, erhältlich sind. Mittels Gemischt Ganzzahliger Programmierung können in einer Vielzahl möglicher Lösungen globale Maxima gefunden werden, so dass eine besonders gute Lösung gefunden werden kann. Erhältliche Verfahren bzw. Vorrichtungen zur Gemischt Ganzzahligen Programmierung werden laufend verbessert, sodass zu erwarten ist, dass zukünftig noch bessere Optimierungsergebnisse erzielbar sein werden.

Es kann ein Maß vorbestimmt sein bzw. werden, das einen Anteil an einem Unterschied zwischen der Kennzahl und einer maximal erreichbaren Zuordnungsgüte ausdrückt. Dieser Unterschied wird auch "Gap" genannt. Es wird bevorzugt, ein Optimierungsverfahren zu verwenden, bei dem dieser "Gap" bestimmt werden kann. Das kann insbesondere mit der Gemischt Ganzzahlige Programmierung erreicht werden.

Aus der erfindungsgemäß bestimmten fixen Pipettenwechslerrüstung(en) resultiert eine Produktivitätssteigerung in der/denn Produktionsstätte(n), indem
- Rüstaufwand für die Pipetten deutlich reduziert wird
- (längerfristig) der Planungsaufwand reduziert wird,
- die Produktivität durch kürzere Durchlaufzeiten, kürzere Umrüstzeiten und kürzere Produktionszeiten erhöht wird.
- Flexibilität, Durchsatz, Liefertreue werden erhöht

Ein weiterer Aspekt der Erfindung sieht ein System, insbesondere eine Produktionsplanungs- und/oder Steuerungssystem, umfassend mindestens eine Recheneinheit bzw. Prozessor, die dazu konfiguriert ist, das die computergestützte Bestimmung der einen oder mehreren Pipettenwechslerfestrüstungen nach dem oben beschriebenen Verfahren auszuführen und eine Steuerungsvorrichtung dazu zu initiieren, dass eine Leiterplattenbestückung mit Hilfe der einen oder mehreren Pipettenwechslerfestrüstungen mit den zu dieser Bestückung notwendigen Bauelementen durchgeführt wird.

Das System bzw. die Vorrichtung und ggf. dazugehörige Einheit(en) sind dazu eingerichtet, solche Verfahrensschritte auszuführen, und können hardware-, firmware- und/oder softwaremäßig implementiert sein.

Ein weiterer Aspekt der Erfindung ist ein Computerprogramm(-produkt) umfassend einen durch eine Recheneinheit bzw. Prozessor ausführbaren Programmkode, welches Befehle aufweist, die die Ausführung des Verfahrens nach einer der oben genannten Ausführungsformen auf dem System der oben genannten Art und/oder auf einem anderen Datenverarbeitungssystem veranlassen.

Das Computerprogramm bzw. -produkt kann auf einem computerlesbaren Speichermedium bzw. Datenträger gespeichert sein. Es ist möglich, dass das Computerprogramm(-produkt) in ein Datenträgersignal eingebunden ist, das für ein Herunterladen desselben von einem Server auf ein Speichermedium vorgesehen ist. Das Computerprogramm bzw. -produkt kann in einer üblichen Programmiersprache (z.B. C++, Java) erstellt sein. Eine Verarbeitungseinrichtung bzw. Prozessor für die Ausführung dessen Programmkodes/Programmkodemodule kann einen marktüblichen Computer oder Server mit entsprechenden Eingabe-, Ausgabe- und Speichermitteln umfassen. Diese Verarbeitungseinrichtung bzw. Recheneinheit kann im Datenverarbeitungssystem bzw. System der oben genannten Art bzw. in deren Einheiten integriert sein oder in dem System bzw. in den Systemkomponenten implementiert sein.

Das computer-implementierte Verfahren betrifft auch sogenannte Cloud-Dienste (Cloud = Rechnerwolke). Eine Rechnerwolke um fasst in der Regel ein oder mehrere Server, die von einem Cloud-Diensterbringers betrieben werden und dazu eingerichtet sind, einen Cloud-Dienst an einen Dienstnehmer z.B. einem Werkverbund zu liefern. Demnach kann Datenverarbeitungssystem in einer Rechnerwolke realisiert sein.

Das System, das Datenverarbeitungssystem und die Vorrichtungen sowie das Computerprogramm(-produkt) und Datenträger bzw. Datenträgersignal können analog zum oben genannten Verfahren und dessen Weiterbildungen weiter- bzw. ausgebildet sein.

Beim obigen computer-implementierten Verfahren kann unter "vorgegeben" bzw. "vorgebbar" verstanden werden, dass ein oder mehrere Eingabewerte bereits, beispielsweise durch Standard(werte), festgelegt sind oder von einem Benutzer und/oder durch Ausgabewerte eines vorgeschalteten computerimplementierten Verfahrens vorgegeben bzw. festgelegt werden und/oder vorgebbar bzw. festlegbar sind. Damit werden diese Eingabewerte vom computer-implementierten Verfahren erfasst.

Weitere Vorteile, Einzelheiten und Weiterbildungen der Erfindung ergeben sich aus der nachfolgenden Beschreibung von Ausführungsbeispielen in Verbindung mit den Zeichnungen.
- Figur 1: zeigt ein beispielhaftes Montagewerk mit Bestückungslinien zur Leiterplattenfertigung, und
- Figur 2: zeigt ein Beispiel für einen Bestückungsautomat einer Bestückungslinie mit drei Twinhead-Bestückköpfen, dazugehörige Pipettenwechsler und ein gerüsteter Pipettenwechsler.

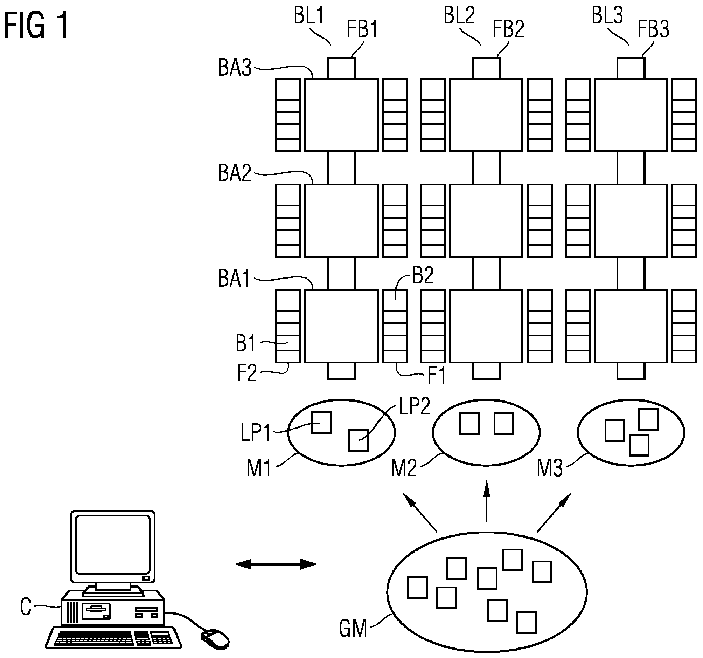

Figur 1 zeigt ein beispielhaftes Montagewerk bzw. eine Montageanlage mit Bestückungslinien BL1 - BL3 zur Leiterplattenfertigung. Eine Bestückungslinie z.B. BL1 besteht üblicherweise aus Bestückautomaten BA1 - BA3, wobei an jeder Bestückungslinie jeweils durch ein Transportsystem FB1 - FB3 (z.B. Förderbänder) zum Transport der zu bestückenden Leiterplatten z.B. LP1, LP2 miteinander verbunden sind. Die auf die Leiterplatten zu bestückenden Bauelemente bzw. Bauteile z.B. B1, B2 werden üblicherweise über (Rüst-)Tische mit einer Vielzahl von Zuführvorrichtungen z.B. F1, F2 am Bestückungsautomaten BA1 bzw. an anderen Bestückungsautomaten BA2, BA3 bereitgestellt. Jeder Bestückungsautomat umfasst einen oder mehrere Bestückungsköpfe, die jeweils dazu eingerichtet sind, von den Zuführvorrichtungen eines Rüsttisches Bauelemente bzw. -teile B1, B2 aufzunehmen und an einer vorbestimmten Bestückposition auf der Baugruppe bzw. Leiterplatte zu positionieren, die sich auf dem Transportsystem befindet. Für die Bereitstellung der Bauelemente werden z.B. sogenannte Gurt-Feeder eingesetzt, welche zum Transport und Zuführen von in Gurten gelagerten Bauteilen geeignet sind. Diese transportieren die in taschenartigen Vertiefungen magazinierten Bauteile zu einer Abholposition, an der die Bauteile von dem Bestückkopf aus den Gurttaschen abgeholt werden. Der leere Gurt verlässt die Zuführvorrichtung an einer geeigneten Stelle.

Aus einer Gesamtmenge GM von Leiterplatten sollen jeweils einer Bestückungslinie eine Menge M1 - M3 von Leiterplatten zugewiesen werden, um eine möglichst minimale Bauelementevarianz der Linien BL1 - BL3 zu erreichen. Mit der Bauelementevarianz einer Linie BL1 - BL3 wird die Anzahl der auf der Linie verwendeten Bauelementtypen bezeichnet. Weiterhin ist bei der Zuordnung der Leiterplatten zu den Linien BL1 - BL3 zu berücksichtigen, dass die Leiterplatten auf den Linien BL4 - BL6 meist auch unterschiedliche Produktionszeiten besitzen. Zudem dürfen die maximalen Produktionszeitkapazitäten der jeweiligen Linien BL1 - BL3 nicht überschritten werden.

Eine Steuerungsvorrichtung bzw. -system C ordnet die Leiterplatten LP1, LP2 auf der Bestückungslinie einer Rüstfamilie zu. Eine Rüstfamilie ist eine Menge von Leiterplattentypen, deren Leiterplatten vollständig mit Bauelementen von Bauelementtypen bestückt werden können, die in der Bauelemente-Rüstung auf den Rüsttischen bereitgestellt sind. Eine Rüstfamilie ist/wird üblicherweise genau einer Rüstung zugeordnet und umgekehrt.

Die Bestimmung der Zuordnungen der Leiterplatten aus der Gesamtmenge GM auf die Mengen M1 - M3, die dann auf der jeweiligen Linie BL1 - BL3 gefertigt werden, erfolgt beispielsweise mittels des Verfahrens aus DE 10 2011 076 565 B4.

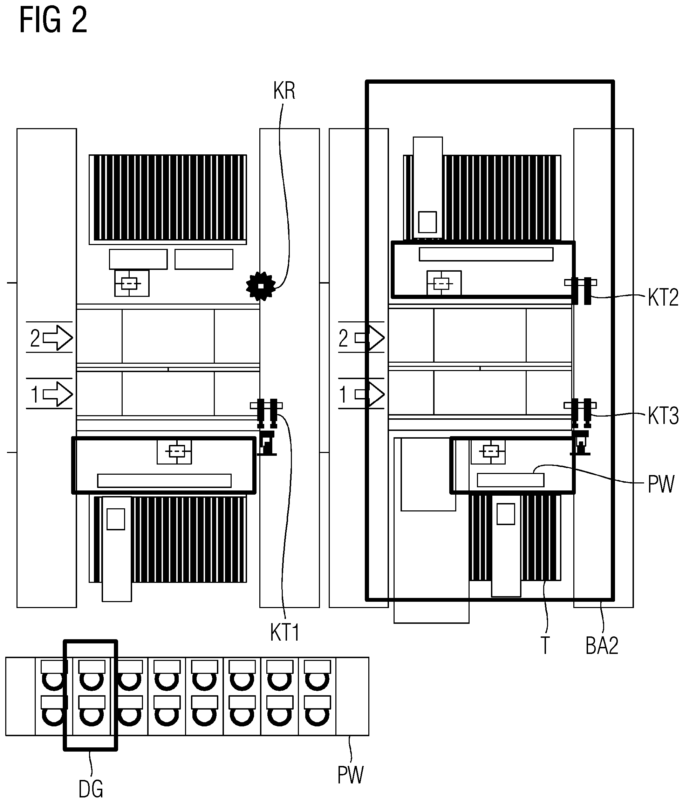

Figur 2 zeigt ein Beispiel für einen Bestückungsautomat BA2 einer Bestückungslinie mit zwei Twinhead-Bestückköpfen KT 2 und KT3, dazugehörige Pipettenwechsler und ein gerüsteter Pipettenwechsler PW.

Im Beispiel zu Figur 2 sind zwei Twinhead-Bestückköpfe KT2, KT3 am Bestückautomat BA2 mit Pipettenwechslern pro Bestückkopf. Pipettenwechsler PW weist beispielsweise 8 Magazine auf. Ein Magazin kann mit zwei Fächern, genannt Doppelgarage, oder aber auch mit nur einem Fach, genannt Einzelgarage, oder mit mehreren Fächern ausgestaltet sein.

In einer solchen beispielhaften Konstellation werden zu Beginn vorzugsweise die Typen der Bauelemente der zu bestückenden Baugruppen bestimmt, die mit Twinhead-Bestückköpfen setzbar sein sollen. Das sind zum einen die Bauelemente, die unbedingt mit Twinhead-Bestückköpfen gesetzt werden müssen. Zum anderen gibt es Bauelemente, die zwar auch mit anderen Bestückköpfen gesetzt werden könnten, für die es aber vorteilhaft sein kann, wenn sie mit einem Twinhead-Bestückkopf bestückt werden. Bauelemente, die sowohl mit dem Twinhead als auch mit einem CPP-Bestückkopf (Revolverbestückkopf) KR bestückt werden können und die beim CPP-Bestückkopf die externe Kamera benötigen, sind ein Beispiel dafür.

Gemäß einer Ausführungsform der Erfindung kann das erfindungsgemäße Verfahren fixe Twinhead-Pipettenwechslerrüstungen ermitteln, mit denen beispielsweise die eingangs beschriebene Planungssoftware der Firma ASMPT SMT zulässige und hinsichtlich der Produktionszeit gute Bauelement-Ergebnis-Rüstungen für die zu bestückenden Baugruppen finden kann. Um zulässige Bauelement-Rüstungen gewährleisten zu können, müssen für alle zu bestückenden Bauelemente jeweils Pipetten in den Pipettenwechslern bereitstehen, mit denen ein Bestückkopf das jeweilige Bauelement von einem möglichen Rüsttisch T abholen und bestücken kann.

Lösungen mit den besten Produktionszeiten werden mit freien unbelegten Pipettenwechslerrüstungen erzielt. Eine ungünstige fixe Pipettenwechslerrüstung kann eine gute Produktionszeit verhindern. Der unten beschriebene MILP-Ansatz zielt deshalb darauf ab, Pipettenwechslerrüstungen zu finden, die für eine Planungssoftware wie der der Firma ASMPT SMT eine möglichst hohe Flexibilität verschaffen.

Das Ziel ist es, die Pipettenwechslerrüstung so zu erstellen, dass die Bauelemente möglichst viele Bestückkopfalternativen haben. Zudem müssen aber Pipetten eines Typs eventuell auch doppelt in einem Pipettenwechsler gerüstet werden, damit gute Produktionszeiten erzielt werden können. Deshalb wird versucht, dass Bauelemente mit vielen Bestückpositionen möglichst mit zwei Pipetten gleichen Typs aus dem Pipettenwechsler gesetzt werden können. Damit können in vielen Fällen besonders gute Twinhead-Taktzeiten erzielt werden. Zum Beispiel: An einem Twinhead werden 20 Bestückpositionen eines Bauelements gesetzt. Ist nur eine Pipette im Pipettenwechsler, die er dafür verwenden kann, dann muss der Twinhead mit einem Segment diese Bestückpositionen setzen. Daraus resultieren 20 Bestückzyklen. Kann er allerdings mit den zwei Pipetten gleichen Typs beide Segmente verwenden, dann benötigt er nur noch 10 Bestückzyklen. Dadurch wird die Bestückzeit fast halbiert.

Im Nachgang an die bestimmte(n) Pipettenwechslerfestrüstung(en) werden die zur Bestückung der Leiterplatten notwendigen Bauelemente, die zu den gerüsteten Pipetten passen, auf die Tische gerüstet. Hierzu kann beispielsweise ein Verfahren zur Festrüstungsbildung auf Bestückungslinien verwendet werden, das beispielsweise aus DE 10 2012 220 904 B4 bekannt ist.

Das Steuerungssystem C ist dazu ausgestaltet, das nachfolgend noch näher erläuterte erfindungsgemäße computer-implementierte Verfahren zur Bestimmung der einen oder mehreren mit Pipetten fest gerüstete Pipettenwechslerfestrüstungen auszuführen. Das System ist mit einem Datenspeicher gekoppelt und kann gespeicherte bzw. vorkonfigurierte Modelle M des Montagewerks abrufen. In das System können eine oder mehrere Optimierungseinheiten integriert oder mit diesem gekoppelt/verbunden sein, die wiederum mit sogenannten Solvern S, z.B. Cplex, Gurobi, gekoppelt sein können. Solver (Löser) sind spezielle mathematische Computerprogramme, die mathematische Probleme numerisch lösen können. In der Optimierungseinheit wird eine Bestimmung der Pipettenwechslerfestrüstung durchgeführt. Eine nicht dargestellte zentrale Steuerungsvorrichtung oder mehrere Steuerungsvorrichtungen, die für eine oder mehrere Gruppe(n) von Bestückungslinien die Steuerung-/Regelung des Leiterplattenbestückungsprozesses auf den Bestückungslinien zur Erfüllung der Bestückungsaufträge eingerichtet ist/sind, kann/können jeweils mit einem Server bzw. Serverfarm, einer Cloud bzw. Rechnerwolke über drahtgebundene und/oder drahtlose Netzwerktechniken verbunden sein. Es ist auch möglich eine zentrale Steuerungsvorrichtung in die Rechnerwolke zu integrieren.

Letztendlich wird die Bestückung der Leiterplatten mittels der einen oder mehreren bestimmten Pipettenwechslerfestrüstungen, insbesondere gesteuert durch das Steuerungssystem, durchgeführt.

Ein Spezialfall von Optimierungsmethoden ist die lineare Optimierung. Sie befasst sich mit der Optimierung linearer Zielfunktionen über einer Menge, die durch lineare Gleichungen und Ungleichungen eingeschränkt ist. Sie ist Grundlage der Lösungsverfahren der (gemischt-) ganzzahligen linearen Optimierung. Im Zusammenhang mit MIP (mixed integer programming) bzw. MILP (gemischt ganzzahlige Lineare Programmierung) können für kleine IP-Programme (ganzzahlige Optimierungsmodelle) Standardsolver wie z.B. CPLEX, Scip, Gurobi, Xpress verwendet werden.

Schwieriger als die lineare Optimierung ist der Fall der nichtlinearen ganzzahliger Optimierung (MINLP), bei der die Zielfunktion, die Nebenbedingungen (NB) oder beide vorliegen können. Die Lösung wird erreicht, indem geeignete lineare Approximationen verwendet werden, so dass Standardsolver direkt verwendet werden können. Darüber hinaus können die oben genannten Standardsolver jeweils bestimmte Arten von nichtlinearen Problemen bereits lösen. Außerdem gibt es zusätzliche Solver, die auf die Lösung nichtlinearer Probleme spezialisiert sind (z.B. ANTIGONE, BARON).

Mit Hilfe von nichtlinearen ganzzahligen Optimierungsverfahren lassen sich die Pipettenwechslerfestrüstungen ermitteln, mit denen eine auf alle Pipettenwechsler bezogene optimale bzw. maximale Kennzahl erzielt wird.

Optimierer auf der Basis Gemischt Ganzzahliger Programmierungen sind - wie oben erläutert - als kommerzielle und nicht-kommerzielle Produkte erhältlich.

Vorteile der Gemischt ganzzahligen linearen Optimierung sind:
- Globaler Optimierungsansatz.
- Leicht erweiterbar.
- Sehr gute kommerzielle Standard-Solver (z.B. Gurobi, SCIP, CPLEX, Ilog, Xpress), die in der Praxis weit verbreitet und bewährt sind.
- Für eine ermittelte Lösung ist bekannt, wie weit sie maximal von der optimalen Lösung entfernt ist (Gap).

Dabei wird im Beispiel als Optimierungskriterium gewählt, das ein Maximum der Summe der Anzahl der setzbaren Bauelementtypen über alle Pipettenwechsler unter Einhaltung einer vorgebbaren maximalen Produktionszeit der zu bestückenden Leiterplatten zum Ziel hat Eine nicht dargestellte Ausgabeeinheit des Systems liefert das Optimierungsergebnis umfassend die Pipettenwechslerfestrüstung in einer zur Steuerung und/oder zur Regelung der Bestückungsauftragserfüllung geeigneten Form. Eine solche Form sollte computerlesebar sein z.B. ein oder mehrere Excellisten in CSV-Format, die die Information enthält, welche Pipette welchen Pipettentyps in den Fächern der Pipettenwechslern zu rüsten ist.

Anschließend kann bewertet werden, vorzugsweise mittels Simulation, welche Auswirkungen die bestimmte Pipettenwechslerfestrüstung(en) auf den Betrieb der einzelnen Bestückungslinien haben.

Gegebenenfalls kann dann die Bestimmung der Pipettenwechslerfestrüstung(en) wiederholt werden. Mit Hilfe der ausgegebenen bestimmten Pipettenwechslerfestrüstung(en) kann beispielsweise ein Gerät bzw. Maschine, insbesondere ein Roboter, und/oder auch durch Fachpersonal die Pipettenwechsler mit den entsprechenden Pipetten der bestimmten Festrüstungspipettentypen bestücken.

Eine nicht dargestellte Recheneinheit der Steuerungsvorrichtung C kann dann die Steuerung und/oder Regelung einer Bestückung von Baugruppen entsprechend vornehmen.

Zusätzlich und alternativ ist es möglich, dass die Steuerungsvorrichtung andere computerlesbare Steuerungssignale in Empfang nimmt, um daraus in ihre Recheneinheit den Steuerungs-/Regelungsprozess zu veranlassen.

Nach Abschluss der Bestimmung der Pipettenwechslerfestrüstung(en) kann die Bestückung an der Bestückungslinien durchgeführt werden. Das Bestücken wird üblicherweise so durchgeführt, dass die Bauelemente einzeln mittels Lötpaste an den Baugruppen/Leiterplatten fixiert werden. Anschließend können die bestückten Leiterplatten in einem Reflow-Ofen fertig gestellt werden, in dem die Lötpaste vorübergehend aufgeschmolzen wird, sodass die Bauelemente elektrisch und mechanisch mit Leiterbahnen an der Oberfläche der Leiterplatte verbunden werden.

Im Folgenden wird ein MILP-Formulierung zur Bestimmung der Pipettenwechslerfestrüstung(en) beschrieben, mit der ausgehend von einer aktuellen Belegung von Bestückungslinien mit zu fertigenden Baugruppentypen über einen Planungszeitraum bestimmt wird, dass vorgegebene (Bestückungs-) linienrestriktionen eingehalten werden (u.a. Produktionszeitschranken) und eine maximale Anzahl an Bauelementtypen gesetzt werden können.

Dabei sind verschiedene Restriktionen zu berücksichtigen:
- Die Kapazitäten der Pipettenwechsler werden eingehalten
- Garantiert wird für die mit Twinhead zu setzenden Bauelemente, dass
   ∘ mindestens eine zulässige Pipette in den Twinhead-Pipettenwechslern an möglichen Rüsttischen verfügbar ist.
- Die Flexibilität/Freiheit für die Baugruppen-Linienverteilung (s.o. zu. Figur 1) wird maximiert:
   ∘ Bauelemente müssen jeweils an möglichst vielen Tischen gerüstet werden können
   ∘ Bauelemente eines Typs sollen an einem Tisch jeweils mit möglichst zwei Pipetten eines Typs gesetzt werden können

In der MIP-Formulierung gelten die folgenden Bezeichnungen:

### Indices

- *R*: Menge der Baugruppentypen
- *NT*: Menge der Pipettentypen
- *C*: Menge der Bauelementtypen der Baugruppentypen R, die mit Pipetten aus NT gesetzt werden können
- *NTSingleRec*: Menge der Pipettentypen, die in Einzelgaragen-Magazinen gerüstet werden müssen
- *NC*: Menge der Pipettenwechsler
- *NC _{c}*: Menge der Pipettenwechsler, auf die Bestückköpfe Zugriff haben, die Bauelemente des Typs c setzen können und die von Rüsttischen abholen dürfen, auf denen Bauelemente des Typs c gerüstet werden dürfen
- *NT _{c}*: Menge der Pipettentypen, mit denen Bauelemente des Typs c gesetzt werden können
- *NT_{nc}*: Menge der Pipettentypen, die im Pipettenwechsler nc gerüstet werden dürfen
- *C_{nt,nc}*: Menge der Bauelementtypen aus C, die mit dem Pipettentyp nt von auf nc zugreifbaren Bestückköpfen gesetzt werden können

### Parameter

- *Cap_{nc}*: Anzahl der Fächer des Pipettenwechslers *nc*
- *CapSingleRec_{nc}*: Anzahl der Einzelgaragen des Pipettenwechslers *nc*
- *PlacementCount_{c}*: Anzahl der gesamten Bestückpositionen des Bauelementtyps c für alle zu bestückenden Baugruppen

### Binärvariablen

- setup_{nt,nc}: Variable, die angibt ob der Pipettentyp nt im Pipettenwechsler nc gerüstet werden muss. (In diesem Fall nimmt sie den Wert 1 an, anderenfalls den Wert 0)
- doubleSetup_{nt,nc}: Variable, die angibt, ob der Pipettentyp nt zweimal im Pipettenwechsler nc gerüstet werden muss. (In diesem Fall nimmt sie den Wert 1 an, anderenfalls den Wert 0)
- isDoubleNtUsable_{c,nc}: Variable, die angibt, ob im Pipettenwechsler nc zwei Pipetten gleichen Typs gerüstet sind mit denen Bauelemente des Typs c gesetzt werden können (In diesem Fall nimmt sie den Wert 1 an, anderenfalls den Wert 0)

**Zielfunktion:** Maximiere über alle Pipettenwechsler die Summe der Anzahlen an Bestückpositionen, die mit zwei Pipetten eines Typs aus dem jeweiligen Pipettenwechsler gesetzt werden können. $Maximiere {\sum }_{c ∈ C} {\sum }_{nc ∈ NC} {PlacementCount}_{c} is {DoubleNtUsable}_{c , nc}$

### Nebenbedingungen:

(1) Jeder Bauteiltyp muss bestückbar sein. Das heißt: Für jeden Bauteiltyp gibt es einen Pipettenwechsler, in dem eine zulässige Pipette für den Bauteiltyp gerüstet ist und einen Bestückkopf, der darauf Zugriff hat, und der mit diesem Pipettentyp Bauteile des Bauteiltyps setzen darf. Zudem müssen Bauteile des Bauteiltyps auch noch auf mindestens einem Tisch, auf dem dieser Bestückkopf zugreifen kann, gerüstet werden können. ${\sum }_{nc ∈ {NC}_{c}} {\sum }_{nt ∈ {NT}_{nc}} {setup}_{nt , nc} \geq 1 c ∈ C$
(2) Die Kapazitäten der Pipettenwechsler müssen eingehalten werden. ${\sum }_{nt ∈ NT} {setup}_{nt , nc} + {doubleSetup}_{nt , nc} \leq {CapNC}_{nc} nc ∈ NC$
(3) Gibt es Pipetten, die in Einzelgaragen gerüstet werden müssen, dann müssen die Kapazitäten der Einzelgaragen Pipettenwechsler dafür ausreichen. ${\sum }_{nt ∈ NTSingleRec} {setup}_{nt , nc} + {doubleSetup}_{nt , nc} \leq {CapSingleRecNC}_{nc} nc ∈ NC$
(4) In einem Pipettenwechsler darf eine zweite Pipette eines Typs nur gerüstet werden, wenn bereits eine erste des Typs gerüstet ist. ${doubleSetup}_{nt , nc} \leq {setup}_{nt , nc} nt ∈ NT , nc ∈ NC$
(5) Für die Bauelemente eines Typs können zwei Pipetten eines Typs aus dem Pipettenwechsler verwendet werden. ${\text{isDoubleNtUsable}}_{\text{c} \text{,nc}} \leq {\sum }_{n t ∈ N {T}_{c} : n t ∈ N {T}_{n c}} d o u b l e S {\text{etup}}_{\text{nt} \text{,nc}} c ∈ C , n c ∈ N C$
(6) Sind in einem Pipettenwechsler gerüstete Pipetten eines Pipettentyps nicht verwendbar, so dürfen sie dort auch nicht gerüstet werden. ${\sum }_{nt ∈ NT : nt ∉ {NT}_{nc}} {setup}_{nt , nc} = 0 nc ∈ NC$
(7) In einem Pipettenwechsler dürfen nur Pipetten gerüstet werden, mit denen auch Bauelemente gesetzt werden können.
(8) Zusätzlich zur oben genannten Zielfunktion oder alternative kann eine zweite Zielfunktion vorgesehen sein: Maximiere die Summe der Anzahl der setzbaren Bauelemente über alle Pipettenwechsler
(9) Die Zielfunktionen können mit unterschiedlichen Gewichtungen versehen werden.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Die Implementierung der vorstehend beschriebenen Prozesse oder Verfahrensabläufe/-schritte kann anhand von Befehlen bzw. Instruktionen erfolgen, die auf computerlesbaren, nichtflüchtigen Speichermedien oder in flüchtigen Computerspeichern (im Folgenden zusammenfassend als computerlesbare Speicher bezeichnet) vorliegen. Computerlesbare Speicher sind beispielsweise flüchtige Speicher wie Caches, Puffer oder RAM sowie nichtflüchtige Speicher wie Wechseldatenträger, Festplatten, usw.

Die vorstehend beschriebenen Funktionen oder Schritte können dabei in Form zumindest eines Instruktionssatzes in/auf einem computerlesbaren Speicher vorliegen. Die Funktionen oder Schritte sind dabei nicht an einen bestimmten Instruktionssatz oder an eine bestimmte Form von Instruktionssätzen oder an ein bestimmtes Speichermedium oder an einen bestimmten Prozessor oder an bestimmte Ausführungsschemata gebunden und können durch Software, Firmware, Microcode, Hardware, Prozessoren, integrierte Schaltungen usw. im Alleinbetrieb oder in beliebiger Kombination ausgeführt werden. Dabei können verschiedenste Verarbeitungsstrategien zum Einsatz kommen, beispielsweise serielle Verarbeitung durch einen einzelnen Prozessor oder Multiprocessing oder Multitasking oder Parallelverarbeitung usw.

Die Instruktionen können in lokalen Speichern abgelegt sein, es ist aber auch möglich, die Instruktionen auf einem entfernten System z.B. Cloud abzulegen und darauf via Netzwerk zuzugreifen.

Unter "rechner-/computergestützt" bzw. "computer-implementiert" kann im Zusammenhang mit der Erfindung beispielsweise eine Implementierung des Verfahrens verstanden werden, bei dem insbesondere ein Prozessor bzw. eine Recheneinheit, der Teil der (Steuerungs- bzw. Verarbeitungs-) vorrichtung bzw. -einheit und/oder eines Computers und/oder eines oder mehrerer Dienste in einer Rechnerwolke (Cloud) eines Diensterbringers sein kann, mindestens einen Verfahrensschritt des Verfahrens ausführt.

Sofern es in der nachfolgenden Beschreibung nicht anders angegeben ist, beziehen sich die Begriffe "abbilden", "nachbilden", "empfangen", "anwenden", "ausgeben", "bereitstellen" und dergleichen vorzugsweise auf Handlungen und/oder Prozesse und/oder Verarbeitungsschritte, die Daten verändern und/oder erzeugen und/oder die Daten in andere Daten überführen, wobei die Daten insbesondere als physikalische Größen dargestellt oder vorliegen können.

Der Begriff "Prozessor", "zentrale Signalverarbeitung", "Steuereinheit" oder "Datenauswertemittel", wie hier verwendet, umfasst Verarbeitungsmittel im weitesten Sinne, also beispielsweise Server, Universalprozessoren, Grafikprozessoren, digitale Signalprozessoren, anwendungsspezifische integrierte Schaltungen (ASICs), programmierbare Logikschaltungen wie FPGAs, diskrete analoge oder digitale Schaltungen und beliebige Kombinationen davon, einschließlich aller anderen dem Fachmann bekannten oder in Zukunft entwickelten Verarbeitungsmittel. Prozessoren können dabei aus einer oder mehreren Systemen bzw. Vorrichtungen bzw. Einrichtungen bzw. Einheiten bestehen. Besteht ein Prozessor aus mehreren Vorrichtungen, können diese zur parallelen oder sequentiellen Verarbeitung bzw. Ausführung von Instruktionen ausgelegt bzw. konfiguriert sein. Unter einer "Speichereinheit" kann im Zusammenhang mit der Erfindung beispielsweise ein computerlesbares Speichermedium in Form von Arbeitsspeicher (engl. Random-Access Memory, RAM) oder eine Festplatte verstanden werden.

## Patentansprüche

1. Verfahren zum Bestücken von Leiterplatten (LP1, LP2) eines oder mehrerer zu fertigenden Leiterplattentypen auf einer Bestückungslinie (BL1, BL2, BL3) mittels einer Pipettenwechslerrüstung von Pipetten eines oder mehrerer verschiedener Pipettentypen in einem oder mehreren Pipettenwechslern (PW), wobei eine oder mehrere gerüstete Pipetten jeweils von einem Segment eines Bestückungskopf (KT1, KT2, KT3; KR) aufgenommen werden können, **dadurch gekennzeichnet, dass** computergestützt für eine Menge an zu bestückenden Leiterplatten eine oder mehrere mit Pipetten fest gerüstete Pipettenwechslerfestrüstungen mit einem Optimierungskriterium über einen vorgebbaren Planungszeitraum bestimmt werden, wobei mit Hilfe der einen oder mehreren bestimmten Pipettenwechslerfestrüstungen alle Leiterplatten der Bestückungslinie bestückt werden können und wobei das Optimierungskriterium ein Maximum der Summe der Anzahlen der auf die Leiterplatten setzbaren Bauelemente über alle Pipettenwechsler zum Ziel hat.

2. Verfahren nach dem vorhergehenden Anspruch, **dadurch gekennzeichnet, dass** die Bestückung der Leiterplatten mittels der einen oder mehreren bestimmten Pipettenwechslerfestrüstungen durchgeführt wird.

3. Verfahren nach dem vorhergehenden Anspruch 1 oder 2, **dadurch gekennzeichnet, dass** die Pipettenwechslerfestrüstung(en) so bestimmt werden, dass es für jeden Bauelementtyp einer ersten Menge von Bauelementtypen, dessen Bauelemente, mit denen die zu fertigenden Leiterplatten zu bestücken sind, mit Bestückköpfen gesetzt werden müssen, die aus den Pipettenwechslerfestrüstungen Pipetten aufnehmen, einen Pipettenwechsler gibt, in dem zumindest eine Pipette passend zum jeweiligen oben genannten Bauelementtyp gerüstet wird.

4. Verfahren nach einem der vorhergehenden Ansprüche, **dadurch gekennzeichnet, dass** die Pipettenwechslerfestrüstung(en) so bestimmt werden, dass es für jeden Bauelementtyp einer zweiten Menge von Bauelementtypen ohne der ersten Menge von Bauelementtypen, dessen Bauelemente, mit denen die zu fertigenden Leiterplatten zu bestücken sind, mit Bestückköpfen gesetzt werden können, die aus den Pipettenwechslerfestrüstungen Pipetten aufnehmen, einen Pipettenwechsler gibt, in dem zumindest eine Pipette passend zum jeweiligen oben genannten Bauelementtyp gerüstet wird.

5. Verfahren nach einem der vorhergehenden Ansprüche, **dadurch gekennzeichnet, dass** jeder Bestückkopf von einem oder mehreren Tischen (T) der Bestückungslinien Bauelemente eines Bauelementtyps, der zum Pipettentyp einer der aufgenommenen Pipetten passt, abholen und damit die Bestückungspositionen einer Leiterplatte setzen kann.

6. Verfahren nach einem der vorhergehenden Ansprüche, **dadurch gekennzeichnet, dass** n Pipetten eines Pipettentyps in einem Pipettenwechsler gerüstet werden, wenn eine Bestückungskopf n Segmente zur Aufnahme der n Pipetten aufweist.

7. Verfahren nach einem der vorhergehenden Ansprüche, **dadurch gekennzeichnet, dass** die eine oder mehrere Pipettenwechslerfestrüstungen mit einem weiteren Optimierungskriterium bestimmt wird, welches ein Maximum der Summe der Anzahlen an Bestückpositionen über alle Pipettenwechsler, die mit einer Pipette oder zwei Pipetten eines Pipettentyps aus dem jeweiligen Pipettenwechsler gesetzt werden können, zum Ziel hat.

8. Verfahren nach einem der vorhergehenden Ansprüche, **dadurch gekennzeichnet, dass** zur Bestimmung der einen oder mehreren bestimmten Pipettenwechslerfestrüstungen als Eingabedaten folgende Daten verwendet werden:
- Menge der Leiterplattentypen;
- Menge der Pipettentypen;
- Menge der Pipettenwechsler;
- Menge der Bauelementtypen eines Leiterplattentyps, die mit Pipetten aus der Pipettentypmenge gesetzt werden können;
- Menge der Pipettenwechsler, auf die Bestückköpfe Zugriff haben, die Bauelemente eines bestimmten Bauelementtyps setzen können und diese von Tischen abholen dürfen, auf denen Bauelemente dieses Bauelementtyps gerüstet werden;
- Menge der Pipettentypen, mit denen Bauelemente eines bestimmten Bauelementtyps gesetzt werden können;
- Menge der Pipettentypen, die in einem bestimmten Pipettenwechsler gerüstet werden dürfen;
- Menge der Bauelementtypen, die mit einem bestimmten Pipettentyp von auf den entsprechenden Pipettenwechsler zugreifbaren Bestückköpfen gesetzt werden können,
- Anzahl der zur Bestückung zu verwendenden Bauelemente pro Bauelementtyp für alle zu bestückenden Leiterplatten.

9. Verfahren nach einem der vorhergehenden Ansprüche, **dadurch gekennzeichnet, dass** die jeweiligen Kapazitäten des einen oder mehreren Pipettenwechsler berücksichtigt werden.

10. Verfahren nach einem der vorhergehenden Ansprüche, **dadurch gekennzeichnet, dass** die Beschaffenheit der Magazine innerhalb eines Pipettenwechslers berücksichtigt werden.

11. Verfahren nach einem der vorhergehenden Ansprüche, **dadurch gekennzeichnet, dass** die eine oder mehreren Pipettenwechslerfestrüstungen mittels ganzzahliger linearer Programmierung bestimmt werden.

12. System (C) umfassend mindestens eine Recheneinheit, die dazu konfiguriert ist, das computergestützte Bestimmung der einen oder mehreren Pipettenwechslerfestrüstungen nach einem der vorhergehenden Verfahrensansprüche auszuführen und eine Steuerungsvorrichtung dazu zu initiieren, dass eine Leiterplattenbestückung mit Hilfe der einen oder mehreren Pipettenwechslerfestrüstungen mit den zu dieser Bestückung notwendigen Bauelementen (B1, B2) durchgeführt wird.

13. Computerprogrammprodukt umfassend einen durch mindestens eine Recheneinheit ausführbaren Programmkode, welches Befehle aufweist, die die Ausführung des Verfahrens nach einem der vorhergehenden Verfahrensansprüche veranlassen.
